Europäisches Patentamt

European Patent Office

Office européen des brevets

(19)

(11)    **EP 1 275 968 B1**

(12)    **FASCICULE DE BREVET EUROPEEN**

| | |
|---|---|
| (45) Date de publication et mention de la délivrance du brevet: **22.09.2004 Bulletin 2004/39** | (51) Int Cl.⁷: **G01R 29/08** |

(21) Numéro de dépôt: **02291768.6**

(22) Date de dépôt: **12.07.2002**

(54) **Dispositif portable pour la mesure et l'analyse du champ électromagnetique ambiant**

Tragbare Einrichtung zu Messung und Analyse des umgebenden elektromagnetischen Feldes

Portable device for measuring and analysing the ambient electromagnetic field

(84) Etats contractants désignés:
**AT BE BG CH CY CZ DE DK EE ES FI FR GB GR IE IT LI LU MC NL PT SE SK TR**

(30) Priorité: **12.07.2001 FR 0109314**

(43) Date de publication de la demande:
**15.01.2003 Bulletin 2003/03**

(73) Titulaire: **Bouygues Telecom**
**92100 Boulogne Billancourt (FR)**

(72) Inventeurs:
• **VEYSETT Remy**
**78220 VIROFLAY (FR)**

• **CHAUVIN Sébastien**
**78150 ROCQUENCOURT (FR)**
• **PICARD Dominique**
**78830 BONNELLES (FR)**
• **FLEURY Gilles**
**75003 PARIS (FR)**
• **LE BRUSQUET Laurent**
**75014 PARIS (FR)**

(74) Mandataire: **Callon de Lamarck, Jean-Robert et al**
**Cabinet Régimbeau**
**20, rue de Chazelles**
**75847 Paris cedex 17 (FR)**

(56) Documents cités:
**WO-A-01/46705**

**Description**

L'invention concerne les mesures du rayonnement électromagnétique ambiant, et en particulier du rayonnement généré par les voies balises de stations de base (BTS) des réseaux de téléphonie cellulaire.

Elle trouve notamment - mais non limitativement - avantageusement application aux mesures de rayonnement de réseaux GSM ou DCS.

La multiplication des appareils électriques et électroniques tels que les appareils ménagers, les téléviseurs et les téléphones mobiles a entraîné une augmentation des rayonnements électromagnétiques dans l'espace ambiant. L'influence de ces rayonnements sur l'organisme est encore mal connue. Néanmoins, l'Agence Nationale des Fréquences (ANFR) a publié - avant la date de priorité de la présente demande de brevet - un document provisoire visant à établir un "Protocole de mesure in situ" des émissions électromagnétiques pour des niveaux de champs compris entre 9 kHz et 300 GHz. Un document définitif a été plus récemment rendu accessible.

Ce document reprend des niveaux de référence du champ électrique et du champ magnétique qui ont été arrêtés, pour différentes gammes de fréquences, dans une « recommandation du Conseil de l'union Européenne » du 12 juillet 1999 relative à la limitation de l'exposition du public aux champs électromagnétiques (acte publié au Journal Officiel des Communautés européennes du 30 juillet 1999). En France, ces niveaux de référence ont également fait l'objet du décret 2002-775 du 3 mai 2002

Le document WO 01/46705 propose un dispositif d'analyse du champ électromagnétique ambiant comprenant un module de mesure du champ relié à un analyseur de spectre et une unité de commande et de traitement incluant un micro-ordinateur. L'unité de commande et de traitement calcule, à partir des données enregistrées par l'analyseur de spectre, une valeur de composante efficace moyenne de champ électrique ou magnétique. Pour chaque fréquence d'échantillonnage, cette valeur est comparée à une valeur seuil.

Un tel dispositif ne permet pas de distinguer, au sein du rayonnement électromagnétique ambiant, le rayonnement émis par des stations de base d'un réseau cellulaire. Par conséquent, il ne permet pas de déterminer si un niveau de rayonnement électromagnétique ambiant élevé est dû ou non à la proximité de ces stations de base.

Pour détecter les émissions générées par les stations de base, les techniques utilisées actuellement consistent à faire défiler rapidement une série de traces acquises par un analyseur de spectre. Les fréquences correspondant aux voies balises des stations de base sont repérées grâce à la persistance rétinienne ; elles sont en effet remarquables par leur propriété de faible variation temporelle et leur niveau d'intensité relativement important.

Une telle technique ne peut être utilisée que par des opérateurs expérimentés et conduit à un taux de détection faible (<50%) et à un taux d'erreur de détection inacceptable (>50%).

Le but de l'invention est de fournir un outil permettant de détecter de manière automatique les fréquences des voies balises des stations de bases d'un réseau cellulaire, afin de permettre une détermination du niveau des champs rayonnés par les stations de base..

A cet effet, l'invention propose un procédé d'analyse du champ électromagnétique ambiant dans lequel, pour déterminer le niveau de champ d'un ou plusieurs réseaux de télécommunication cellulaire, on analyse le champ aux fréquences des voies balises de stations de base du ou desdits réseaux, caractérisé en ce qu'il comprend les étapes selon lesquelles :

-   à l'aide de moyens de détection, on mesure dans le temps, pour plusieurs fréquences d'une gamme de fréquences que l'on échantillonne, l'intensité du champ électromagnétique,
-   une unité de traitement détermine pour chaque fréquence, à partir des mesures ainsi effectuées, au moins un paramètre caractéristique du champ électromagnétique,
-   l'unité de traitement détermine à partir des valeurs de ce paramètre caractéristique, les fréquences qui correspondent aux signaux des voies balises d'une ou plusieurs stations de base, en appliquant un critère de sélection basé sur les propriétés statistiques du champ rayonné par ce type de station.

Ce procédé permet avantageusement de mesurer l'intensité du rayonnement émis par les stations de base d'un réseau de télécommunication cellulaire. Ces intensités pourront ensuite être comparées, après extrapolation à trafic maximal, à des valeurs seuil, correspondant par exemple aux niveaux de référence fixés par les textes réglementaires.

L'intensité du champ électromagnétique peut être déterminée à partir de la mesure du champ magnétique et/ou du champ électrique.

De manière préférentielle, l'un des paramètres caractéristiques déterminé est choisi parmi les paramètres suivants : l'intensité moyenne du champ électromagnétique, l'écart-type de la variation de l'intensité du champ électromagnétique, la période de variation du champ électromagnétique, l'intensité minimale du champ électromagnétique, la demi-somme des quartiles 1 et 3 de l'intensité du champ électromagnétique, la différence entre le quartile 2 et l'écart entre les quartiles 1 et 3 de l'intensité du champ électromagnétique.

Dans une mise en oeuvre de l'invention, pour une fréquence donnée, un paramètre caractéristique considéré est la médiane et en ce qu'on détermine les fréquences des stations de base d'un réseau de télécommunication cellulaire en prenant en considération celles pour lesquelles la médiane est maximale.

Dans une autre mise en oeuvre de l'invention, pour une fréquence donnée, un paramètre caractéristique considéré est l'intensité moyenne du champ électromagnétique à cette fréquence, et l'unité de traitement détermine les fréquences des voies balises des stations de base d'un réseau de télécommunication cellulaire en prenant en considération celles pour lesquelles l'intensité moyenne est maximale.

Cette mise en oeuvre permet avantageusement de détecter les niveaux de champs électromagnétiques générés par les stations de base les plus proches.

Dans une autre mise en oeuvre de l'invention, pour une fréquence donnée, un paramètre caractéristique considéré est l'écart-type de la variation de l'intensité du champ électromagnétique mesuré à cette fréquence, et l'unité de traitement détermine les fréquences des voies balises des stations de base d'un réseau de télécommunication cellulaire en prenant en considération celles pour lesquelles l'écart-type normalisé est minimal.

Dans une autre mise en oeuvre, pour une fréquence donnée, un paramètre caractéristique considéré est la période de variation du champ électromagnétique à cette fréquence, et l'unité de traitement détermine les fréquences des voies balises des stations de base d'un réseau de télécommunication cellulaire en prenant en considération celles pour lesquelles l'intensité du signal présente une variation périodique.

Dans une autre mise en oeuvre de l'invention, pour une fréquence donnée, un paramètre caractéristique considéré est l'intensité minimale du champ électromagnétique à cette fréquence, et l'unité de traitement détermine les fréquences des voies balises des stations de base d'un réseau de télécommunication cellulaire en prenant en considération celles pour lesquelles l'intensité minimale est maximale.

Dans une autre mise en oeuvre de l'invention, pour une fréquence donnée, un paramètre caractéristique considéré est la demi-somme des quartiles 1 et 3 de l'intensité du champ électromagnétique, et l'unité de traitement détermine les fréquences des voies balises des stations de base d'un réseau de télécommunication cellulaire en prenant en considération celles pour lesquelles cette demi-somme des quartiles 1 et 3 est maximale.

Dans une autre mise en oeuvre de l'invention, pour une fréquence donnée, un paramètre caractéristique considéré est la différence entre le quartile 2 et l'écart entre les quartiles 1 et 3 de l'intensité du champ électromagnétique, et l'unité de traitement détermine les fréquences des voies balises des stations de base d'un réseau de télécommunication cellulaire en prenant en considération celles pour lesquelles la différence entre le quartile 2 et l'écart entre les quartiles 1 et 3 est maximale.

Dans une autre mise en oeuvre de l'invention, pour une fréquence donnée, l'unité de traitement détermine au moins deux paramètres caractéristiques et construit un diagramme de Pareto incluant pour chaque fréquence d'échantillonnage un point représentatif de ces paramètres, l'unité de traitement sélectionne ensuite les points situés dans une zone du diagramme dans laquelle sont localisées des stations de base.

De manière avantageuse, des paramètres caractéristiques représentés sur le diagramme de Pareto peuvent être l'intensité moyenne du champ électromagnétique et l'écart-type de la variation de l'intensité du champ électromagnétique.

De manière avantageuse, des paramètres caractéristiques représentés sur le diagramme de Pareto peuvent être le quartile 2 de l'intensité du champ électromagnétique et la différence des quartiles 1 et 3 de l'intensité du champ électromagnétique.

Enfin, l'unité de traitement compare les niveaux d'intensité du champ électromagnétique mesuré aux fréquences des stations de bases sélectionnées avec des valeurs de référence.

L'invention concerne également un dispositif portable d'analyse du champ électromagnétique ambiant, caractérisé en ce qu'il comprend des moyens de détection du champ électromagnétique, un analyseur de spectre qui est relié à ces moyens de détection et qui analyse le spectre du champ électromagnétique détecté, et une unité de traitement apte à mettre en oeuvre le procédé d'analyse précédemment défini à partir des mesures fournies par l'analyseur de spectre.

Ce dispositif permet avantageusement de réaliser des mesures de champ électromagnétique au point géographique auquel on souhaite connaître l'intensité du rayonnement électromagnétique ambiant.

Dans une mise en oeuvre de ce dispositif, les moyens de détection comportent au moins deux antennes, l'une dont la bande passante s'étend de 20 Hz à 1 MHz, l'autre dont la bande passante s'étend de 80 MHz à 3 GHz.

Avantageusement, notamment, les moyens de détection comportent au moins une troisième antenne dont la bande passante s'étend entre 1 et 80 MHz.

D'autres caractéristiques et avantages ressortiront encore de la description qui suit, laquelle est purement illustrative et non limitative et doit être lue en regard des figures annexées parmi lesquelles :

- la figure 1 représente un dispositif de détection du champ électromagnétique conforme à un mode de réalisation de l'invention,

EP 1 275 968 B1

- la figure 2 représente le diagramme de Pareto moyenne/écart-type, obtenu pour une série de mesure et utilisé dans un mode de mis en oeuvre du procédé de l'invention.

Les stations de base (BTS) transmettent régulièrement sur le canal "Broad Casting Channel" (BCCH) des informations de localisation vers les stations mobiles. La puissance émise par ces stations de base est quasi-constante de manière à ce qu'une station mobile puisse être localisée en fonction du niveau de puissance qu'elle reçoit. Ainsi, le rayonnement électromagnétique ambiant est plus important à proximité des stations de base.

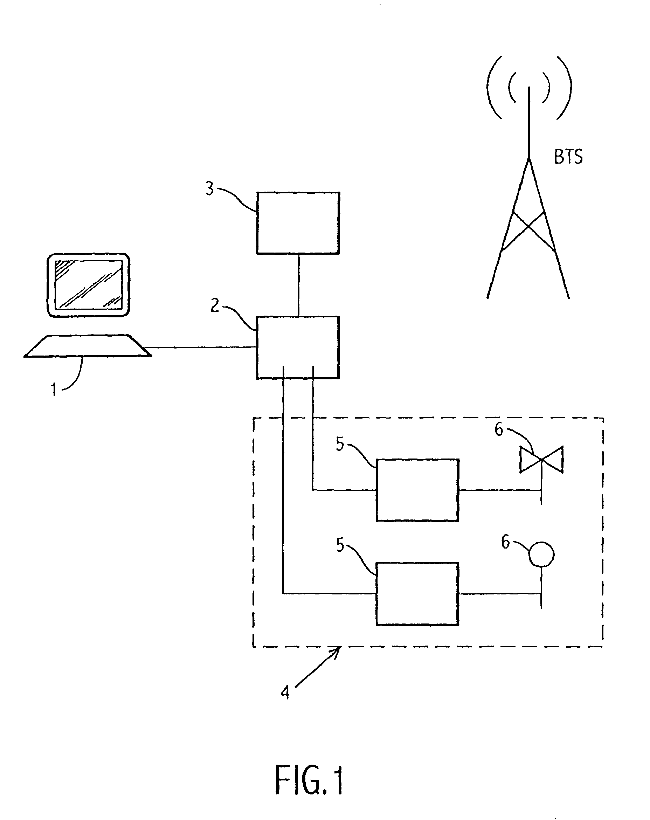

Sur la figure 1, le dispositif de détection du champ électromagnétique comprend un PC portable 1 comprenant un logiciel de contrôle et des moyens de traitement, connecté à un analyseur de spectre 2. L'analyseur de spectre 2 peut être par exemple du type HP 8560EC fourni par la société Hewlett Packard. Il est relié à des moyens d'alimentation autonomes 3. Le dispositif comprend en outre des moyens de détection 4 pouvant être connectés à l'analyseur de spectre 2. Les moyens de détection 4 utilisés dépendent des gammes de fréquence que l'on souhaite analyser. Ces moyens de détection comprennent des amplificateurs 5 chacun associé à une antenne 6. Les antennes 6 sont disposées à l'endroit précis où l'on souhaite connaître le champ électromagnétique.

Pour la détection des fréquences comprises entre 10Hz et 1 MHz, on utilise par exemple une antenne boucle 7604 de diamètre 13 cm fournie par Electrometrics associée à un amplificateur basse fréquence HP 11729-60014 fourni par Hewlett Packard. Pour la détection des fréquences comprises entre 80MHz et 2900MHz, on utilise un amplificateur haute fréquence HP 87405A fourni par Hewlett Packard associé à une antenne biconique ARC PCD8250

Pour la détection des fréquences comprises entre 1MHz et 80MHz, on utilise une troisième antenne qui est par exemple une antenne SCHWARZBECK 1545.

Les « niveaux d'exposition de référence » auxquels se réfère l'ANFR permettent la comparaison avec les valeurs de champ électrique et de champ magnétique mesurées. Ces niveaux de référence sont donnés pour chaque gamme de fréquence entre 0 et 300 GHz dans le tableau 1 :

| Gamme de fréquences | Champ électrique E (V/m) | Champ magnétique H (A/m) |
|---|---|---|
| 0 à 1 Hz | | 32 000 |
| 1 à 8 Hz | 10 000 | $32000/f^2$ |
| 8 à 25 Hz | 10 000 | $4000/f$ |
| 0,025 à 0,8 kHz | $250/f$ | $4/f$ |
| 0,8 à 3 kHz | $250/f$ | 5 |
| 3 à 150 kHz | 87 | 5 |
| 0,15 à 1 MHz | 87 | $0,73/f$ |
| 1 à 10 MHz | $87/f^{1/2}$ | $0,73/f$ |
| 10 à 400 MHz | 28 | 0,073 |

| 400 à 2000 MHz | $1,375 \times f^{1/2}$ | $0,0037 \times f^{1/2}$ |
|---|---|---|
| 2 à 300 GHz | 61 | 0,16 |

f est la fréquence à laquelle le champ est mesurée considérée dans l'unité indiquée dans la colonne de la gamme de fréquence.

**Tableau 1 :** Valeurs de référence préconisées dans la recommandation du Conseil de l'union Européenne du 12 juillet 1999 relative à la limitation de l'exposition du public aux champs électromagnétiques (de 0 à 300 GHz).

Pour une gamme de fréquence définie précédemment, on réalise un nombre n d'acquisitions échelonnées dans le temps. A cet effet, on installe l'antenne 6 appropriée aux fréquences à détecter. On saisit à l'aide du PC 1 les informations nécessaires à la définition de cette gamme. Le logiciel de contrôle cherche dans un fichier les paramètres de configuration de l'analyseur de spectre 2 et le configure en conséquence. Le logiciel commande ensuite à l'analyseur de spectre l'acquisition des n traces spectrales. Les données de mesure sont enregistrées dans un nouveau fichier.

Après avoir réalisé les mesures en utilisant les différentes antennes sur l'ensemble des gammes de fréquences, l'utilisateur commande l'analyse du spectre total obtenu. Les moyens de traitement permettent de détecter sur cette bande, à partir de ces n acquisitions les fréquences $f_{BCCH}$ des signaux BCCH et leur intensité $E_{BCCH}$.

La sélection des fréquences BCCH est basée sur le fait que les signaux BCCH sont émis par les stations de base avec une puissance quasi-constante et relativement élevée (par rapport aux puissances d'émission des canaux de communication au repos).

Ces propriétés qualitatives permettent de distinguer les signaux émis par les stations de base du bruit ambiant et plus particulièrement des signaux correspondant aux canaux de communication au repos ou aux canaux de communication en charge. En effet, les canaux de communication au repos présentent une faible fluctuation temporelle mais un niveau d'intensité peu élevé. Les canaux de communication en charge peuvent présenter des niveaux d'intensité élevés (lorsqu'ils sont très sollicités) mais présentent une forte fluctuation temporelle.

Le procédé de détection consiste à sélectionner parmi les fréquences échantillonnées, celles qui correspondent le plus probablement aux signaux BCCH. A cet effet, les moyens de traitement déterminent pour chaque fréquence échantillonnée un paramètre caractéristique du champ électromagnétique à cette fréquence et sélectionnent certaines fréquences en appliquant des critères de discrimination prenant en compte les propriétés des fréquences BCCH ci-dessus.

### Critère du maximum des minima (Maximin)

Dans une première mise en oeuvre du procédé de détection, le logiciel de commande commande à l'analyseur de spectre l'acquisition de n traces spectrales dans différentes gammes de fréquences. Pour chaque fréquence $f_i$ échantillonnée, les moyens de traitement déterminent l'intensité $(E_i)_{min}$ minimale mesurée sur l'ensemble des traces $(E_i)_j$ à cette fréquence $f_i$. Les intensités $E_{BCCH}$ correspondant aux signaux BCCH sont considérées comme étant les intensités $(E_i)_{min}$ présentant des valeurs maximales.

Ainsi, selon cette première mise en oeuvre, on a :

$$(E_i)_{\min} = \min_{j}((E_i)_j)$$

$$E_{BCCH} = \max_{i}((E_i)_{\min})$$

$$f_{BCCH} = f(E_{BCCH})$$

Le critère des Maximin donne des résultats assez fiables même s'il ne permet pas toujours de détecter des stations de base de faible niveau. Ce résultat est dû au fait qu'un canal n'est plus représenté que par son minimum. Par conséquent, il suffit que le signal passe une fois par le niveau moyen de bruit pour qu'il ne soit plus considéré comme une station de base potentielle.

### Critère du maximum des médianes (Maximed)

Au lieu de considérer les minima des intensités émises pour chaque fréquence échantillonnée, on peut choisir de considérer la médiane <Q2> des valeurs relevées sur l'ensemble des traces. En effet, la médiane constitue un critère qui résiste mieux aux erreurs ou excès qui peuvent se produire sur les valeurs extrémales. Ainsi, selon cette deuxième mise en oeuvre, on a :

$$< E_{BCCH} >= E(\max_{i}(Q_2)_i)$$

$$f_{BCCH} = f(E_{BCCH})$$

Le critère des Maximed est fiable, et, avec ce critère, le risque d'assimiler des canaux de communication à des stations de base est extrêmement faible.

**Critère des écart-types normalisés minimaux**

Dans une troisième mise en oeuvre du procédé de détection, le logiciel commande à l'analyseur de spectre l'acquisition de n traces spectrales dans les différentes gammes de fréquences. Les moyens de traitement déterminent l'écart-type $\sigma_i$ des intensités $E_i$ pour chaque fréquence $f_i$ échantillonnée du spectre total. Les intensités $E_{BCCH}$ correspondant aux signaux BCCH sont considérées comme étant les intensités présentant les écarts-type normalisés les plus faibles. (Par écart-type « normalisé », on entend le rapport entre l'écart-type et l'intensité moyenne). En effet, les signaux BCCH sont émis à une puissance quasi-constante.

Ainsi, selon cette troisième mise en oeuvre, on a :

$$< E_i >= \frac{1}{n} \sum_{j=1}^{n} (E_i)_j$$

$$\sigma_i = \sqrt{\frac{1}{n} \sum_{j=1}^{n} \left( (E_i)_j - < E_i > \right)^2}$$

$$E_{BCCH} = E\left( \min_i (\sigma_i) \right)$$

$$f_{BCCH} = f(E_{BCCH})$$

**Critère des signaux périodiques**

Dans une quatrième mise en oeuvre du procédé de détection, le logiciel de commande commande à l'analyseur de spectre l'acquisition de n traces spectrales dans les différentes gammes de fréquences. Les n traces spectrales sont acquises avec un intervalle de temps fixe entre chaque acquisition j. Pour chaque fréquence $f_i$ échantillonnée, les moyens de traitement déterminent la période $T_i$ de variation des valeurs d'intensité $E_i$ mesurées. Les signaux BCCH sont des signaux périodiques, ce qui permet de les différencier des autres signaux.

Ainsi, selon cette quatrième mise en oeuvre, on a :

$$T_i = p\acute{e}riode\left( (E_i)_j \right) \text{ tel que } T_i \succ \frac{1}{f_i}$$

**Critère de la demi-somme des quartiles**

Dans une cinquième mise en oeuvre du procédé de détection, le logiciel de commande commande à l'analyseur de spectre l'acquisition de n traces spectrales dans les différentes gammes de fréquences. Pour chaque fréquence $f_i$ échantillonnée, les moyens de traitement déterminent les valeurs des quartiles 1, 2 et 3, notés respectivement $E_{Q1}$, $E_{Q2}$ et $E_{Q3}$, des intensités mesurées.

Le quartile 1, noté $E_{Q1}$ est défini comme la valeur d'intensité pour laquelle un quart des mesures est inférieure ou égale à cette valeur.

Le quartile 2, noté $E_{Q2}$ est défini comme la valeur d'intensité pour laquelle la moitié des mesures est inférieure ou égale à cette valeur ; le quartile 2 correspond à la médiane.

Le quartile 3, noté $E_{Q3}$ est défini comme la valeur d'intensité pour laquelle trois quarts des mesures est inférieure ou égale à cette valeur.

La différence entre les quartiles $E_{Q3}$ et $E_{Q1}$ fournit une estimation de l'écart-type des valeurs d'intensité me-

surées à la fréquence $f_i$.

La demi-somme des quartiles $E_{Q3}$ et $E_{Q1}$ fournit une estimation de la valeur moyenne des intensités mesurées à la fréquence $f_i$.

Les intensités $E_{BCCH}$ correspondant aux signaux BCCH sont considérées comme étant les intensités ($E_i$) pour lesquelles la demi-somme $S_i$ des quartiles $E_{Q1}$ et $E_{Q3}$ est maximale.

Ainsi, selon cette cinquième mise en oeuvre, on a :

$$S_i = \frac{1}{2}\left(E_{Q1}(f_i) + E_{Q3}(f_i)\right)$$

$$S_k = \max_i(S_i)$$

$$f_{BCCH} = f_k$$

Ce critère présente une grande similitude avec le critère du maximum des médianes (Maximed). Toutefois, il permet de moins confondre les canaux de communication sollicités avec les fréquences émises par les stations de base.

**Critère du maximum de la différence entre moyenne et quartiles :**

Dans une sixième mise en oeuvre, du procédé de détection, le logiciel de commande commande à l'analyseur de spectre l'acquisition de n traces spectrales dans les différentes gammes de fréquences. Pour chaque fréquence $f_i$ échantillonnée, les moyens de traitement déterminent les valeurs des quartiles $E_{Q1}$, $E_{Q2}$, $E_{Q3}$ des intensités mesurées.

Les intensités $E_{BCCH}$ correspondant aux signaux BCCH sont considérées comme étant les intensités ($E_i$) pour lesquelles la différence $D_i$ entre le quartile $E_{Q2}$ et l'écart entre les quartiles $E_{Q1}$ et $E_{Q3}$ est maximale.

Ainsi, selon cette sixième mise en oeuvre, on a :

$$D_i = E_{Q2} - (E_{Q3} - E_{Q1})$$

$$D_k = \max_i(D_i)$$

$$f_{BCCH} = f_k$$

**Critère de Pareto**

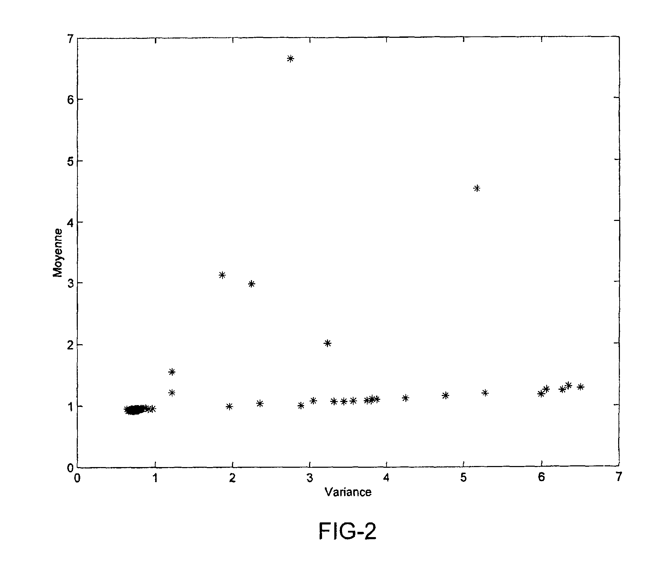

Dans une septième mise en oeuvre, les moyens de traitement établissent le diagramme de Pareto sur au moins deux paramètres caractéristiques. La figure 2 représente un exemple de diagramme de Pareto moyenne/écart-type. Chaque point $P_i$ représenté dans ce diagramme correspond à une fréquence d'échantillonnage $f_i$. Ce point $P_i$ a pour abscisse et pour ordonnée, respectivement l'écart type $\sigma_i$ et la moyenne $<E_i>$ des valeurs des intensités $E_i$ mesurées à cette fréquence.

Ainsi, selon cette septième mise en oeuvre, on a :

$$P_i(\sigma_i, <E_i>)$$

Les signaux susceptibles d'être considérés comme des stations de base sont situés dans une zone correspondant à une portion supérieure, à gauche du diagramme de Pareto.

Les moyens de traitement peuvent bien entendu réaliser des diagrammes de Pareto en combinant d'autres paramètres caractéristiques tels que par exemple la différence des quartiles $E_{Q3}-E_{Q1}$ et la moyenne $E_{Q2}$. Dans ce cas, les signaux susceptibles d'être considérés comme des stations de base sont également situés dans une zone correspondant à une portion supérieure, à gauche du diagramme de Pareto.

Les traitements précédemment décrits ont été appliqués à n=20 traces acquises sur différents sites géographiques pour 601 fréquences d'échantillonnage uniformément réparties sur la gamme de fréquences DCS (Digital Communication System) comprises entre 1,8 GHz et 1,88 GHz. Les résultats sont indiqués dans le tableau 2 ci-dessous.

Tableau 2 :

| Taux de détection correcte obtenu (β) et le taux d'erreur (Z) (canaux de communication détectés comme des stations de base) pour différents critères utilisés. | | | | | | |
|---|---|---|---|---|---|---|
| | Maximin | Maximed | $\frac{1}{2}(E_{Q1} + E_{Q3})$ | $E_{Q2} - (E_{Q3} - E_{Q1})$ | Pareto ($\sigma$,<E>) | Pareto ($E_{Q3} - E_{Q1}$, $E_{Q2}$) |
| β | ~96% | ~97,5% | ~98% | ~97,5% | ~89% | ~85% |
| Z | 4,5% | 3% | 6% | 5% | 7% | 12% |

On constate que les taux de détection correcte β sont bien supérieurs aux taux obtenus avec les procédés de détection de l'art antérieur (ces taux étaient inférieurs à 50%). De plus, les taux d'erreur Z sont inférieurs aux taux d'erreur des procédés de détection de l'art antérieur.

Le procédé de détection proposé ci-dessus est particulièrement adapté à une analyse sur site rapide du champ électromagnétique ambiant. En effet, il permet d'obtenir des résultats fiables à partir d'un nombre restreint d'acquisitions (par exemple n=20).

Bien entendu, il est possible de déterminer à partir des valeurs d'intensité $E_i$ mesurées d'autres paramètres caractéristiques et d'appliquer à ces paramètres d'autres critères, ces critères devant être basés sur les propriétés du champ rayonné par les stations de base.

Pour les fréquences $f_{BCCH}$ des stations de base ainsi déterminées, les moyens de traitement comparent les niveaux d'intensité maximaux du champ électromagnétique mesuré aux fréquences des stations de bases déterminée avec les valeurs de référence proposées par exemple dans le tableau 1. On peut prévoir que le PC 1 affiche le résultat de cette comparaison de manière graphique pour que l'utilisateur puisse immédiatement visualiser les fréquences des voies balises des stations de base pour lesquelles les niveaux de champ électromagnétique de référence sont dépassés.

**Revendications**

**1.** Procédé d'analyse du champ électromagnétique ambiant dans lequel, pour déterminer le niveau de champ d'un ou plusieurs réseaux de télécommunication cellulaire, on analyse le champ aux fréquences des voies balises de stations de base (BTS) du ou desdits réseaux, comprenant les étapes selon lesquelles :

- à l'aide de moyens de détection (4), on mesure dans le temps, pour plusieurs fréquences d'une gamme de fréquences que l'on échantillonne, l'intensité du champ électromagnétique,
- une unité de traitement (1) détermine pour chaque fréquence, à partir des mesures ainsi effectuées, au moins un paramètre caractéristique du champ électromagnétique, et **caractérisé par** l'étape selon laquelle
- l'unité de traitement (1) détermine à partir des valeurs de ce paramètre caractéristique, les fréquences qui correspondent aux signaux des voies balises d'une ou plusieurs stations de base (BTS), en appliquant un critère de sélection basé sur les propriétés statistiques du champ rayonné par ce type de station.

**2.** Procédé selon la revendication 1, **caractérisé en ce que** l'intensité du champ électromagnétique est déterminée à partir de la mesure du champ magnétique et/ou du champ électrique.

**3.** Procédé selon l'une des revendications 1 ou 2, **caractérisé en ce que** l'un des paramètres caractéristiques déterminé est choisi parmi les paramètres suivants : l'intensité moyenne du champ électromagnétique, l'écart-type de la variation de l'intensité du champ électromagnétique, la période de variation du champ électromagnétique, l'intensité minimale du champ électromagnétique, la demi-somme des quartiles 1 et 3 de l'intensité du champ électromagnétique, la différence entre le quartile 2 et l'écart entre les quartiles 1 et 3 de l'intensité du champ électromagnétique.

**4.** Procédé selon l'une des revendications 1 à 3, **caractérisé en ce que**, pour une fréquence donnée, un paramètre caractéristique considéré est l'intensité moyenne du champ électromagnétique à cette fréquence, et **en ce qu'**on détermine les fréquences des voies balises des stations de base (BTS) d'un réseau de télécommunication cellulaire en prenant en considération celles pour lesquelles l'intensité moyenne est maximale.

**5.** Procédé selon l'une des revendications 1 à 3, **caractérisé en ce que**, pour une fréquence donnée, un paramètre caractéristique considéré est l'écart-type de la variation de l'intensité du champ électromagnétique mesuré à cette fréquence, et **en ce qu'**on détermine les fréquences des voies balises des stations de base (BTS) d'un réseau de télécommunication cellulaire en prenant en considération celles pour lesquelles l'écart-type normalisé est minimal.

**6.** Procédé selon l'une des revendications 1 à 3, **caractérisé en ce que**, pour une fréquence donnée, un paramètre caractéristique considéré est la période de variation du champ électromagnétique à cette fréquence, et **en ce qu'**on détermine les fréquences des voies balises des stations de base (BTS) d'un réseau de télécommunication cellulaire en prenant en considération celles pour lesquelles l'intensité du signal présente une variation périodique.

**7.** Procédé selon l'une des revendications 1 à 3, **caractérisé en ce que**, pour une fréquence donnée, un paramètre caractéristique considéré est l'intensité minimale du champ électromagnétique à cette fréquence, et **en ce qu'**on détermine les fréquences des voies balises des stations de base (BTS) d'un réseau de télécommunication cellulaire en prenant en considération celles pour lesquelles l'intensité minimale est maximale.

**8.** Procédé selon l'une des revendications 1 à 3, **caractérisé en ce que**, pour une fréquence donnée, un paramètre caractéristique considéré est la médiane et **en ce qu'**on détermine les fréquences des voies balises des stations de base (BTS) d'un réseau de télécommunication cellulaire en prenant en considération celles pour lesquelles la médiane est maximale.

**9.** Procédé selon l'une des revendications 1 à 3, **caractérisé en ce que**, pour une fréquence donnée, un paramètre caractéristique considéré est la demi-somme des quartiles 1 et 3 de l'intensité du champ électromagnétique, et **en ce qu'**on détermine les fréquences des voies balises des stations de base (BTS) d'un réseau de télécommunication cellulaire en prenant en considération celles pour lesquelles cette demi-somme des quartiles 1 et 3 est maximale.

**10.** Procédé selon l'une des revendications 1 à 3, **caractérisé en ce que**, pour une fréquence donnée, un paramètre caractéristique considéré est la différence entre le quartile 2 et l'écart entre les quartiles 1 et 3 de l'intensité du champ électromagnétique, et **en ce qu'**on détermine les fréquences des voies balises des stations de base (BTS) d'un réseau de télécommunication cellulaire en prenant en considération celles pour lesquelles la différence entre le quartile 2 et l'écart entre les quartiles 1 et 3 est maximale.

**11.** Procédé selon l'une des revendications 1 à 3, **caractérisé en ce que**, pour une fréquence donnée, l'unité de traitement (1) détermine au moins deux paramètres caractéristiques et construit un diagramme de Pareto incluant pour chaque fréquence d'échantillonnage un point représentatif de ces paramètres, l'unité de traitement (1) sélectionne ensuite les points situés dans une zone du diagramme dans laquelle sont localisées des voies balises de stations de base (BTS).

**12.** Procédé selon la revendication 11, **caractérisé en ce que** des paramètres caractéristiques représentés sur le diagramme de Pareto sont le l'intensité moyenne du champ électromagnétique et l'écart-type de la variation de l'intensité du champ électromagnétique.

**13.** Procédé selon la revendication 11, **caractérisé en ce que** des paramètres caractéristiques représentés sur le diagramme de Pareto sont le quartile 2 de l'intensité du champ électromagnétique et la différence des quartiles 1 et 3 de l'intensité du champ électromagnétique.

**14.** Procédé selon l'une des revendications 1 à 12, **caractérisé en ce que** l'unité de traitement (1) compare les niveaux d'intensité du champ électromagnétique mesuré aux fréquences des stations de bases (BTS) sélectionnées avec des valeurs de référence.

**15.** Dispositif portable d'analyse du champ électromagnétique ambiant, comprenant des moyens de détection (4) du champ électromagnétique, un analyseur de spectre (2) qui est relié à ces moyens de détection (4) et qui analyse le spectre du champ électromagnétique détecté, et une unité de traitement (1) **caractérisé en ce que** l'unité de traitement (1) comprend des moyens de mise en oeuvre du procédé d'analyse selon l'une des revendications 1 à 13 à partir des mesures fournies par l'analyseur de spectre (2).

16. Dispositif selon la revendication 15, **caractérisé en ce que** les moyens de détection (4) comportent au moins deux antennes (6), l'une dont la bande passante s'étend de 20 Hz à 1 MHz, l'autre dont la bande passante s'étend de 80 MHz à 3 GHz.

17. Dispositif selon la revendication 15, **caractérisé en ce que** les moyens de détection (4) comportent au moins une troisième antenne (6) dont la bande passante s'étend entre 1 et 80 MHz.

**Patentansprüche**

1. Verfahren zur Analyse des umgebenden elektromagnetischen Feldes bei dem zur Ermittlung der Feldstärke einer oder mehrerer zellularer Telekommunikationsnetze das Feld auf den Frequenzen von Beacon-Kanälen der Basisstationen (BTS) des oder der Netze analysiert wird, wobei es die Schritte umfaßt, nach denen:

   - mittels Detektionsmitteln (4) für mehrere Frequenzen eines abgetasteten Frequenzbereichs die Stärke des elektromagnetischen Felds im zeitlichen Verlauf gemessen wird,
   - eine Verarbeitungseinheit (1) aus den so durchgeführten Messungen für jede Frequenz wenigstens einen charakteristischen Parameter des elektromagnetischen Felds bestimmt, **gekennzeichnet durch** den Schritt, nach dem
   - die Verarbeitungseinheit (1) aus den Werten dieses charakteristischen Parameters die Frequenzen bestimmt, die den Signalen der Beacon-Kanäle einer oder mehrerer Basisstationen (BTS) entsprechen, indem sie ein Auswahlkriterium anwendet, das auf den statistischen Eigenschaften des von dieser Art Station ausgestrahlten Feldes basiert.

2. Verfahren nach Anspruch 1, **dadurch gekennzeichnet, daß** die Stärke des elektromagnetischen Feldes aus der Messung des magnetischen Feldes und/oder des elektrischen Feldes bestimmt wird.

3. Verfahren nach einem der Ansprüche 1 oder 2, **dadurch gekennzeichnet, daß** einer der bestimmten charakteristischen Parameter aus den folgenden Parametern gewählt ist: die mittlere Feldstärke des elektromagnetischen Feldes, die Standardabweichung der Feldstärkeschwankung des elektromagnetischen Feldes, die Periode der Schwankung des elektromagnetischen Feldes, die minimale Feldstärke des elektromagnetischen Feldes, die halbe Summe der Quartile 1 und 3 der Feldstärke des elektromagnetischen Feldes, die Differenz zwischen dem Quartil 2 und dem Abstand zwischen den Quartilen 1 und 3 der Feldstärke des elektromagnetischen Feldes.

4. Verfahren nach einem der Ansprüche 1 bis 3, **dadurch gekennzeichnet, daß** für eine gegebene Frequenz ein betrachteter charakteristischer Parameter die mittlere Feldstärke des elektromagnetischen Feldes bei dieser Frequenz ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die die mittlere Feldstärke maximal ist.

5. Verfahren nach einem der Ansprüche 1 bis 3, **dadurch gekennzeichnet, daß** für eine gegebene Frequenz ein betrachteter charakteristischer Parameter die bei dieser Frequenz gemessene Standardabweichung der Feldstärkeschwankung des elektromagnetischen Feldes ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die die normierte Standardabweichung minimal ist.

6. Verfahren nach einem der Ansprüche 1 bis 3, **dadurch gekennzeichnet, daß** für eine gegebene Frequenz ein betrachteter charakteristischer Parameter die Periode der Schwankung des elektromagnetischen Feldes bei dieser Frequenz ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die die Feldstärke des Signals eine periodische Schwankung aufweist.

7. Verfahren nach einem der Ansprüche 1 bis 3, **dadurch gekennzeichnet, daß** für eine gegebene Frequenz ein betrachteter charakteristischer Parameter die minimale Feldstärke des elektromagnetischen Feldes bei dieser Frequenz ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die die minimale Feldstärke maximal ist.

**8.** Verfahren nach einem der Ansprüche 1 bis 3, **dadurch gekennzeichnet, daß** für eine gegebene Frequenz ein betrachteter charakteristischer Parameter der Medianwert ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die der Medianwert maximal ist.

**9.** Verfahren nach einem der Ansprüche 1 bis 3, **dadurch gekennzeichnet, daß** für eine gegebene Frequenz ein betrachteter charakteristischer Parameter die halbe Summe der Quartile 1 und 3 der Feldstärke des elektromagnetischen Feldes ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die diese halbe Summe der Quartile 1 und 3 maximal ist.

**10.** Verfahren nach einem der Ansprüche 1 bis 3, **dadurch gekennzeichnet, daß** für eine gegebene Frequenz ein betrachteter charakteristischer Parameter die Differenz zwischen dem Quartil 2 und dem Abstand zwischen den Quartilen 1 und 3 der Feldstärke des elektromagnetischen Feldes ist und dadurch, daß die Frequenzen der Beacon-Kanäle der Basisstationen (BTS) eines zellularen Telekommunikationsnetzes dadurch bestimmt werden, daß diejenigen in Betracht gezogen werden, für die die Differenz zwischen dem Quartil 2 und dem Abstand zwischen den Quartilen 1 und 3 maximal ist.

**11.** Verfahren nach einem der Ansprüche 1 bis 3, **dadurch gekennzeichnet, daß** für eine gegebene Frequenz die Verarbeitungseinheit (1) wenigstens zwei charakteristische Parameter bestimmt und ein Paretodiagramm erstellt, das für jede Abtastfrequenz einen Punkt enthält, der diese Parameter darstellt, wobei die Verarbeitungseinheit (1) anschließend die Punkte auswählt, die sich in einem Bereich des Diagramms befinden, in dem die Beacon-Kanäle der Basisstationen (BTS) lokalisiert sind.

**12.** Verfahren nach Anspruch 11, **dadurch gekennzeichnet, daß** die in dem Paretodiagramm dargestellten charakteristischen Parameter die mittlere Feldstärke des elektromagnetischen Feldes und die Standardabweichung der Feldstärkeschwankung des elektromagnetischen Feldes sind.

**13.** Verfahren nach Anspruch 11, **dadurch gekennzeichnet, daß** die in dem Paretodiagramm dargestellten charakteristischen Parameter das Quartil 2 der Feldstärke des elektromagnetischen Feldes und die Differenz der Quartile 1 und 3 der Feldstärke des elektromagnetischen Feldes sind.

**14.** Verfahren nach einem der Ansprüche 1 bis 12, **dadurch gekennzeichnet, daß** die Verarbeitungseinheit (1) die bei den Frequenzen der ausgewählten Basisstationen (BTS) gemessenen Feldstärken mit Referenzwerten vergleicht.

**15.** Tragbare Vorrichtung zur Analyse des umgebenden elektromagnetischen Feldes, die Mittel zur Detektion (4) des elektromagnetischen Feldes, einen Spektrumanalysator (2), der mit diesen Detektionsmitteln (4) verbunden ist und der das Spektrum des detektierten elektromagnetischen Feldes analysiert, und eine Verarbeitungseinheit (1) umfaßt, **dadurch gekennzeichnet, daß** die Verarbeitungseinheit (1) Mittel zum Einsatz des Analyseverfahrens nach einem der Ansprüche 1 bis 13 ausgehend von den Messungen, die durch den Spektrumanalysator (2) bereitgestellt werden, umfaßt.

**16.** Vorrichtung nach Anspruch 15, **dadurch gekennzeichnet, daß** die Detektionsmittel (4) wenigstens zwei Antennen (6) umfassen, wobei der Durchlaßbereich der einen von 20 Hz bis 1 MHz reicht und der Durchlaßbereich der anderen von 80 MHz bis 3 GHz reicht.

**17.** Vorrichtung nach Anspruch 15, **dadurch gekennzeichnet, daß** die Detektionsmittel (4) wenigstens eine dritte Antenne (6) umfassen, deren Durchlaßbereich von 1 bis 80 MHz reicht.

**Claims**

**1.** Process for analysing the ambient electromagnetic field in which, to determine the field level of one or more cellular telecommunication networks, the field is analysed at the frequencies of the beacon pathways of base stations (BTS) of said network or networks, comprising the steps according to which:

- with the aid of detection means (4), the intensity of the electromagnetic field is measured over time for several frequencies of a frequency range which is sampled,
- a processing unit (1) determines for each frequency, from the measurements thus performed, at least one characteristic parameter of the electromagnetic field, and **characterized by** the step according to which
- the processing unit (1) determines from the values of this characteristic parameter, the frequencies which correspond to the signals of the beacon pathways of one or more base stations (BTS), by applying a selection criterion based on the statistical properties of the field radiated by this type of station.

2. Process according to Claim 1, **characterized in that** the intensity of the electromagnetic field is determined from the measurement of the magnetic field and/or of the electric field.

3. Process according to one of Claims 1 or 2, **characterized in that** one of the characteristic parameters determined is chosen from the following parameters: the mean intensity of the electromagnetic field, the standard deviation of the variation in the intensity of the electromagnetic field, the period of variation of the electromagnetic field, the minimum intensity of the electromagnetic field, the half-sum of quartiles 1 and 3 of the intensity of the electromagnetic field, the difference between quartile 2 and the discrepancy between quartiles 1 and 3 of the intensity of the electromagnetic field.

4. Process according to one of Claims 1 to 3, **characterized in that**, for a given frequency, a relevant characteristic parameter is the mean intensity of the electromagnetic field at this frequency, and **in that** the frequencies of the beacon pathways of the base stations (BTS) of a cellular telecommunication network are determined by taking into consideration those for which the mean intensity is a maximum.

5. Process according to one of Claims 1 to 3, **characterized in that**, for a given frequency, a relevant characteristic parameter is the standard deviation of the variation in the intensity of the electromagnetic field measured at this frequency, and **in that** the frequencies of the beacon pathways of the base stations (BTS) of a cellular telecommunication network are determined by taking into consideration those for which the normalized standard deviation is a minimum.

6. Process according to one of Claims 1 to 3, **characterized in that**, for a given frequency, a relevant characteristic parameter is the period of variation of the electromagnetic field at this frequency, and **in that** the frequencies of the beacon pathways of the base stations (BTS) of a cellular telecommunication network are determined by taking into consideration those for which the intensity of the signal exhibits a periodic variation.

7. Process according to one of Claims 1 to 3, **characterized in that**, for a given frequency, a relevant characteristic parameter is the minimum intensity of the electromagnetic field at this frequency, and **in that** the frequencies of the beacon pathways of the base stations (BTS) of a cellular telecommunication network are determined by taking into consideration those for which the minimum intensity is a maximum.

8. Process according to one of Claims 1 to 3, **characterized in that**, for a given frequency, a relevant characteristic parameter is the median, and **in that** the frequencies of the beacon pathways of the base stations (BTS) of a cellular telecommunication network are determined by taking into consideration those for which the median is a maximum.

9. Process according to one of Claims 1 to 3, **characterized in that**, for a given frequency, a relevant characteristic parameter is the half-sum of quartiles 1 and 3 of the intensity of the electromagnetic field, and **in that** the frequencies of the beacon pathways of the base stations (BTS) of a cellular telecommunication network are determined by taking into consideration those for which this half-sum of quartiles 1 and 3 is a maximum.

10. Process according to one of Claims 1 to 3, **characterized in that**, for a given frequency, a relevant characteristic parameter is the difference between quartile 2 and the discrepancy between quartiles 1 and 3 of the intensity of the electromagnetic field, and **in that** the frequencies of the beacon pathways of the base stations (BTS) of a cellular telecommunication network are determined by taking into consideration those for which the difference between quartile 2 and the discrepancy between quartiles 1 and 3 is a maximum.

11. Process according to one of Claims 1 to 3, **characterized in that**, for a given frequency, the processing unit (1) determines at least two characteristic parameters and constructs a Pareto diagram including for each sampling frequency a point representative of these parameters, the processing unit (1) then selects the points situated in a zone of the diagram in which beacon pathways of base stations (BTS) are located.

12. Process according to Claim 11, **characterized in that** characteristic parameters represented on the Pareto diagram are the mean intensity of the electromagnetic field and the standard deviation of the variation in the intensity of the electromagnetic field.

13. Process according to Claim 11, **characterized in that** characteristic parameters represented on the Pareto diagram are quartile 2 of the intensity of the electromagnetic field and the difference of quartiles 1 and 3 of the intensity of the electromagnetic field.

14. Process according to one of Claims 1 to 12, **characterized in that** the processing unit (1) compares the levels of intensity of the electromagnetic field measured at the frequencies of the selected base stations (BTS) with reference values.

15. Portable device for analysing the ambient electromagnetic field, comprising means of detection (4) of the electromagnetic field, a spectrum analyser (2) which is linked to these means of detection (4) and which analyses the spectrum of the electromagnetic field detected, and a processing unit (1), **characterized in that** the processing unit (1) comprises means for implementing the analysis process according to one of Claims 1 to 13 on the basis of the measurements provided by the spectrum analyser (2).

16. Device according to Claim 15, **characterized in that** the means of detection (4) comprise at least two antennas (6), the bandwidth of the one extending from 20 Hz to 1 MHz, the bandwith of the other extending from 80 MHz to 3 GHz.

17. Device according to Claim 15, **characterized in that** the means of detection (4) comprise at least one third antenna (6) whose bandwidth extends between 1 and 80 MHz.

FIG. 1

FIG-2